# EUROPEAN PATENT APPLICATION

(11) **EP 1 783 554 A1**
(43) Date of publication of application: **09.05.2007**
(21) Application number: 05751379.8
(22) Date of filing: 16.06.2005
(51) Int. Cl.: G03F 7/20, H01L 21/027, H01L 21/68

(54) **EXPOSURE EQUIPMENT**

(30) Priority: 17.06.2004 JP 2004179637
(71) Applicant: TOHOKU UNIVERSITY, Aoba-ku Sendai-shi, Miyagi 980-8577 (JP); Nihon Ceratec Co., Ltd., Sendai-shi, Miyagi 981-3292 (JP); TAIHEIYO CEMENT CORPORATION, Tokyo 104-8518 (JP)
(72) Inventor: OHMI, Tadahiro;, Sendai, Miyagi 9800813 (JP); TAKEHISA, Kiwamu;, Sendai-shi, Miyagi 9800866 (JP); MORIYAMA, S., NIHON CERATEC CO., LTD., Sendai-shi, Miyagi 9813206 (JP); SASAKI, S., NIHON CERATEC CO., LTD., Sendai-shi, Miyagi 9813206 (JP); HIROSE, M., NIHON CERATEC CO., LTD., Sendai-shi, Miyagi 9813206 (JP); ISHII, M., TAIHEIYO CEMENT CORPORATION, Sakura-shi, Chiba 2850802 (JP); SUGAYA, T., TAIHEIYO CEMENT CORPORATION, Sakura-shi, Chiba 2850802 (JP); KATAOKA, M., TAIHEIYO CEMENT CORPORATION, Sakura-shi, Chiba 2850802 (JP); UMEZU, Motohiro c/o TAIHEIYO CEMENT CORPORATION, akura-shi, Chiba 2850802 (JP)
(74) Representative: Glawe, Delfs, Moll
(86) International application number: PCT/JP2005/011013
(87) International publication number: WO 2005/124466

(57) **Abstract**

In a stage member for use in an exposure apparatus, a honeycomb structural body has walls that are extended in a direction perpendicular to a longitudinal direction of the stage member and that surround square shaped prismatic spaces, so as to accomplish a high resistance and a high resonant frequency with respect to torsional vibration. The honeycomb structural body of the stage member is preferably made of a ceramic material.

## Description

### Technical Field

This invention relates to an exposure apparatus and, in particular, relates to an exposure apparatus suitable for manufacturing liquid crystal panels and to a stage member for use in the exposure apparatus.

### Background Art

In order to manufacture a liquid crystal panel, it is necessary to form, on a substrate, a TFT circuit pattern for controlling a liquid crystal display element. In order to form the circuit pattern on the substrate, a mask having a circuit pattern is used to transfer and expose the pattern of the mask onto the substrate. An apparatus for exposure is called a liquid crystal panel exposure apparatus which usually comprises a stage member movably holding at least one of the mask and the substrate.

On the other hand, a semiconductor device exposure apparatus for use in the manufacture of semiconductor devices is also identical with the liquid crystal panel exposure apparatus in principle and in basic structure. In the semiconductor device exposure apparatus, thermal expansion of a stage member resulting from changes of ambient temperature adversely affects a pattern to be exposed. In view of this, use is often made, as a material of a stage member, of a ceramic material which is relatively small in expansion coefficient. For example, a stage member of a semiconductor device exposure apparatus is disclosed in Japanese Unexamined Patent Application Publication (JP-A)No. 11-223690 (Patent Document 1) and using a ceramic material as a constituent material of a stage member of a semiconductor device exposure apparatus is disclosed, for example, in Japanese Patent (JP-B) No. 3260340 (Patent Document 2).

In a liquid crystal panel exposure apparatus, the sizes of a mask and a substrate increase by one digit as compared with those in a semiconductor device exposure apparatus. Accordingly, in order to realize a large and strong stage member, a great deal of a ceramic material should be used as a stage material in the liquid crystal panel exposure.

However, as a result of using the great deal of a ceramic material, there is often the case where the weight of the stage member reaches even several tons and the weight of the entire exposure apparatus reaches even about 20 tons. Further, in order to prevent generation of vibration due to a large reaction force caused by the heavy stage member upon changing its moving direction to the opposite direction, an installation location of the exposure apparatus must be stout or robust.

Furthermore, let consideration be made about a clean room for manufacturing a liquid crystal panel. In this event, when an installation location for the liquid crystal panel exposure apparatus has a stout structure, there have also been problems such that not only the construction cost of the clean room increases, but also the installation location of the liquid crystal panel exposure apparatus is fixed. This thus results in poor flexibility of the productivity. Furthermore, the number of liquid crystal panel exposure apparatuses to be installed should be determined on designing the clean room.

As described above, the ceramic material used for the stage member of the semiconductor device exposure apparatus is also used as the stage member of the conventional liquid crystal panel exposure apparatus. In this connection, a solid structural body, i.e. a dense body of a ceramic material is utilized as the stage member like in the semiconductor device exposure apparatus and needs a great deal of a ceramic material. Hence, the entire apparatus becomes quite heavy, thereby causing various disadvantages.

Taking this into account, if a reduction in thickness or the like of the stage member is carried out for reducing the weight of the stage, since the resonant frequency of the stage member decreases, a response frequency to the control of the stage member is reduced. Such a reduction of the response frequency makes high-speed/high-accuracy control difficult.

Further, the present inventors have proposed a stage member with a honeycomb structure made of a ceramic material in Japanese Unexamined Patent Application Publication (JP-A) No. 2003-402458 Specification (Patent Document 3). This stage member has a high resonant frequency and can realize a reduction in weight.

Patent Document 1 : Japanese Unexamined Patent Application Publication (JP-A) No. 11-223690
Patent Document 2 : Japanese Patent (JP-B) No. 3260340
Patent Document 3 : Japanese Patent Application No. 2003-402458

### Disclosure of the Invention

### Problem to be Solved by the Invention

It has been found that the honeycomb structural ceramic stage member having square shaped prismatic spaces as described in Patent Document 3 exhibits a low resonant frequency with respect to torsional vibration. Further, it has also been found that there occurs a difference in resistance with respect to torsional deformation depending on the shape of walls defining the prismatic spaces.

Therefore, it is an object of this invention to provide an exposure apparatus adapted to exhibit a high resistance to torsional deformation and a stage member for use in such an exposure apparatus.

It is another object of this invention to provide a stage member that can maintain a high resonant frequency even with respect to torsional vibration.

### Means for Solving the Problem

According to one aspect of this invention, there is provided an exposure apparatus adapted to transfer/expose a pattern of a mask onto a substrate while moving at least one of the mask and the substrate by a ceramic stage member, wherein the stage member comprises a plate member of a low-thermal-expansion ceramic material, a honeycomb structural body of a low-thermal-expansion ceramic material and joined to the plate member at its opening surface, and a joining portion joining together the plate member and the honeycomb structural body and made of a low-thermal-expansion ceramic material having a melting temperature lower than that of the ceramic material forming the plate member and the honeycomb structural body, the exposure apparatus characterized in that prismatic spaces of the honeycomb structural body each have a square shape and walls of the prismatic spaces are arranged in a direction perpendicular to a longitudinal direction of the stage member.

In this case, the stage member desirably has a structure in which ceramic plates are joined to the honeycomb structural ceramic body on its upper and lower sides. Preferably, a total mass of the stage member is 1/4 to 1/2 in comparison with that of a ceramic dense body which is free from the prismatic spaces of the honeycomb structural ceramic body.

According to another aspect of this invention, there is provided the exposure apparatus mentioned above, characterized in that the low-thermal-expansion ceramic forming the plate member and the honeycomb structural body and the low-thermal-expansion ceramic forming the joining portion are respectively made of a composite material obtained by combining a first material formed by one or more selected from a group consisting of lithium aluminosilicate, potassium zirconium phosphate, and cordierite, and a second material formed by one or more selected from a group consisting of silicon carbide, silicon nitride, sialon, alumina, zirconia, mullite, zircon, aluminum nitride, calcium silicate, and boron carbide, and that the composite material at 23°C has an average thermal expansion coefficient of -0.1×10⁻⁶ to 0.1×10⁻⁶/°C, a density of 2.45 to 2.55g/cm³, and a Young's modulus of 130 to 160GPa.

In this case, the stage member desirably has a structure in which the prismatic spaces of the honeycomb structural ceramic body are hermetically sealed.

Desirably, a difference between an average thermal expansion coefficient of the plate member and the honeycomb structural body at 23°C and that of the joining portion at 23°C falls within the range of ±0.1×10⁻⁶/°C. The stage member preferably has a structure that physically withstands a difference in stress caused by a gas pressure difference between an inside and an outside.

According to another aspect of this invention, there is provided a liquid crystal panel exposure apparatus adapted to transfer/expose a pattern of a mask onto a substrate while moving at least one of the mask and the substrate by a ceramic stage member, the liquid crystal panel exposure apparatus characterized in that a ceramic material forming the stage member is made of a composite material obtained by combining a first material formed by one or more selected from a group consisting of lithium aluminosilicate, potassium zirconium phosphate, and cordierite, and a second material formed by one or more selected from a group consisting of silicon carbide, silicon nitride, sialon, alumina, zirconia, mullite, zircon, aluminum nitride, calcium silicate, and boron carbide, and that the composite material at 23°C has an average thermal expansion coefficient of -0.1×10⁻⁶ to 0.1×10⁻⁶/°C, a density of 2.45 to 2.55g/cm³, and a Young's modulus of 130 to 160GPa.

In this case, the stage member desirably has a structure in which ceramic plates of the composite material are joined to a honeycomb structural ceramic body of the composite material, on its upper and lower sides. Preferably, a total mass of the stage member is 1/4 to 1/2 as compared with that of a dense body which is free from prismatic spaces portions of the honeycomb structural ceramic body and which is formed by the composite material.

Further, according to another mode of this invention, there is obtained a stage member with a honeycomb structure having prismatic spaces surrounded by walls which are perpendicular to a direction of torsional deformation.

### Effect of the Invention

According to this invention, there are obtained a stage member adapted to exhibit a high resistance and a high resonant frequency with respect to torsional vibration and an exposure apparatus including such a stage member. To this end, the stage member including a honeycomb structural ceramic body has square shaped primatic spaces and the walls of the square shaped prismatic spaces are arranged perpendicularly to a direction of torsion.

### Brief Description of the Drawings

[Fig. 1] is a diagram showing a schematic structure of a stage member for use in an exposure apparatus according to an embodiment of this invention.
[Fig. 2] is a perspective view showing the stage member shown in Fig. 1, with a part cut away.
[Fig. 3] is a diagram showing a honeycomb structural body of a stage member according to Example of this invention.
[Fig. 4] is a diagram showing a honeycomb structural body of Comparative Example 1 for use in comparison with the honeycomb structure according to Example of this invention.
[Fig. 5] is a diagram showing a honeycomb structural body of Comparative Example 2.
[Fig. 6] is a diagram showing a honeycomb structural body of Comparative Example 3.
[Fig. 7] is a diagram showing a honeycomb structural body of Comparative Example 4.
[Fig. 8] is a diagram showing a honeycomb structural body of Comparative Example 5.
[Fig. 9] is a diagram showing a honeycomb structural body of Comparative Example 6.
[Fig. 10] is a diagram showing a honeycomb structural body of Comparative Example 7.

### Description of Symbols

- 11: upper plate member
- 12: lower plate member
- 13: honeycomb structural body
- 14: rail

### Best Mode for Carrying Out the Invention

Hereinbelow, an embodiment of this invention will be described with reference to the drawings.

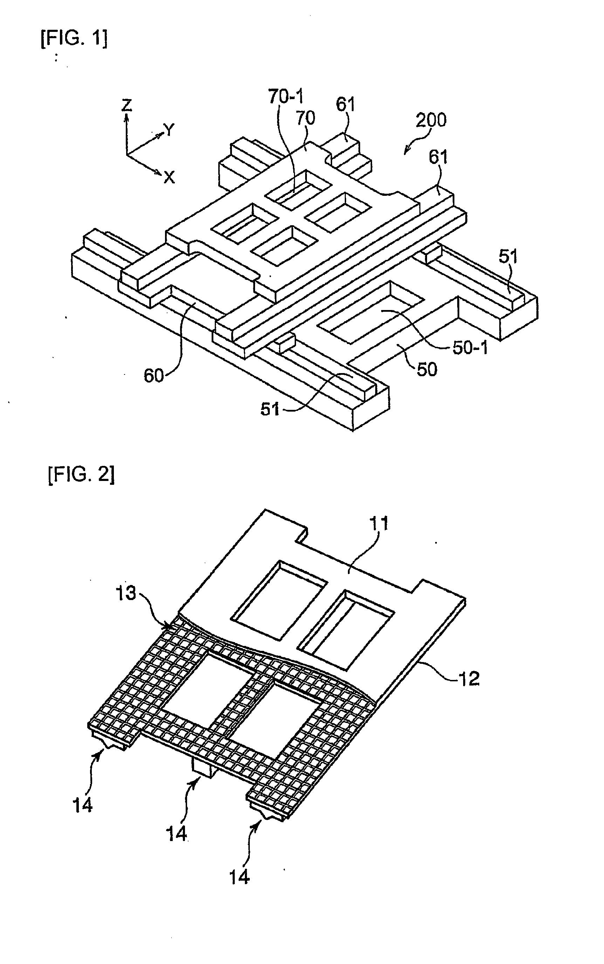

Referring to Fig. 1, there is shown an example of a stage member according to one embodiment of this invention. The illustrated stage member is used as a substrate stage 200 adapted to hold a substrate. Herein, the substrate stage 200 comprises a base 50 forming a stage guide, a stage 60 forming another stage guide, and a stage platform 70. Two guide members 51 for guiding X-direction reciprocating movement of the stage 60 are provided on the base 50, while two guide members 61 for guiding Y-direction reciprocating movement of the stage platform 70 are provided on the stage 60. The stage 60 and the stage platform 70 are driven, for example, by linear motors. The base 50, the stage 60, and the stage platform 70 are ceramic stage members according to this invention, respectively. Herein, the base 50, the stage 60, and the stage platform 70 are each formed with one or more openings 50-1 or 70-1 (illustration of openings of the stage 60 is omitted) for reducing the weight thereof.

Referring to Fig. 2, the specific structure of the stage member according to this invention will be described. As clear from the figure, the stage member comprises upper and lower plate members 11 and 12 formed by a low thermal expansion ceramic and a honeycomb structural body 13 formed by the low thermal expansion ceramic material and joined to the plate members on its opening surfaces. Further, rails 14 are provided on the lower side of the illustrated stage member. Herein, the upper and lower plate members 11 and 12 and the honeycomb structural body 13 are joined together through joining portions formed by a low thermal expansion ceramic material having a melting temperature lower than that of the low thermal expansion ceramic material forming the upper and lower plate members and the honeycomb structural body.

In this case, the stage member preferably has the structure in which the ceramic plates are joined to the honeycomb structural ceramic body on its upper and lower sides. Further, the total mass of the stage member is preferably 1/4 to 1/2 as compared with that of a dense body in which prismatic spaces of the honeycomb structural ceramic body are completely filled with the ceramic material.

The upper and lower plate members 11 and 12 and the honeycomb structural body 13 are made of the low thermal expansion ceramic material formed by a first material formed by one or more selected from a group consisting of lithium aluminosilicate, potassium zirconium phosphate, and cordierite. On the other hand, the low thermal expansion ceramic material of the joining portions is formed by a composite material obtained by combining the first material and a second material formed by one or more selected from a group consisting of silicon carbide, silicon nitride, sialon, alumina, zirconia, mullite, zircon, aluminum nitride, calcium silicate, and boron carbide. In this case, the composite material at 23°C had an average thermal expansion coefficient of -0.1×10⁻⁶ to 0.1×10⁻⁶/°C, a density of 2.45 to 2.55g/cm³, and a Young's modulus of 130 to 160GPa. Further, a difference between the average thermal expansion coefficient of the upper and lower plate members 11 and 12 and the honeycomb structural body 13 at 23°C and that of the joining portions at 23°C was in the range of ±0.1×10⁻⁶/°C.

In this case, the stage member is configured such that the prismatic spaces of the honeycomb structural ceramic body are hermetically sealed and is further configured so as to physically withstand a difference in stress caused by a gas pressure difference between an outside and an inside due to the hermetic sealing.

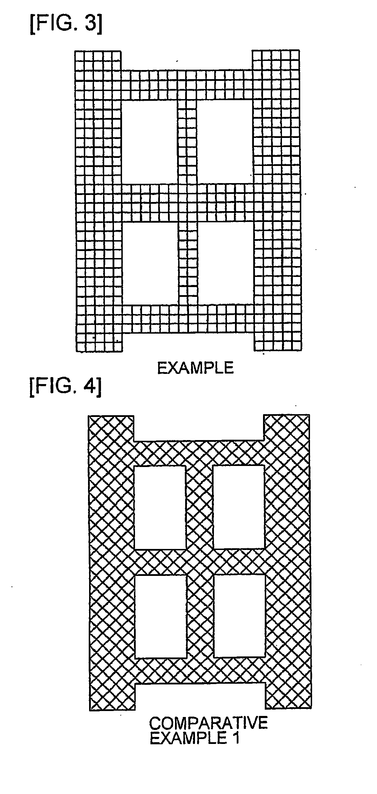

As shown in Figs. 2 and 3, the prismiatic spaces of the honeycomb structural body 13 according to this invention each have a square prismatic shape and walls of the prismiatic spaces are arranged in a direction perpendicular to a longitudinal direction of the stage member. That is, it is understood that the inside of the honeycomb structural body 13 is divided by the walls that are perpendicular to the outer walls surrounding the honeycomb structural body 13.

It has been found out that the honeycomb structural body 13 having such inner walls exhibits a strong resistance to torsional vibration and torsional deformation applied in lateral directions in Fig. 3 and has a high resonant frequency. Herein, the stage member shown in Figs. 2 and 3 has a shape of 450×350×20mm, wherein the thickness of each of the ceramic panels forming the upper and lower members 11 and 12 is 5mm and the thickness of the honeycomb structural body 13 is 10mm. The volume ratio of the honeycomb structural body 13 is 12.5% and the thickness of each of the walls forming the spaces is 0.9mm. As clear from the figures, the spaces of the honeycomb structural body 13 each have a square shape, and the honeycomb structural body 13 is made of a material having a specific gravity of 2.50 and a Young's modulus of 150MPa.

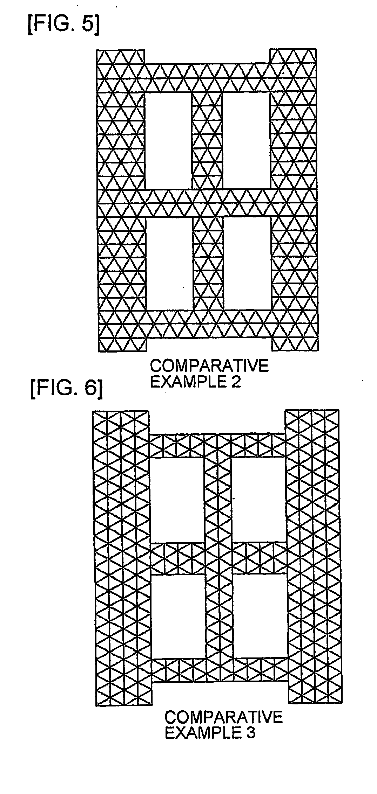

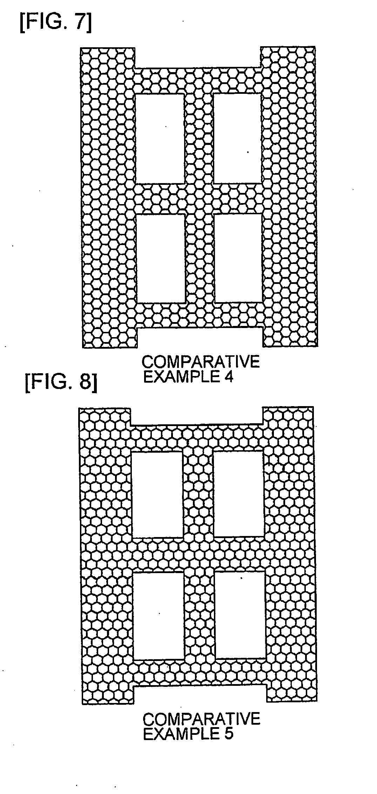

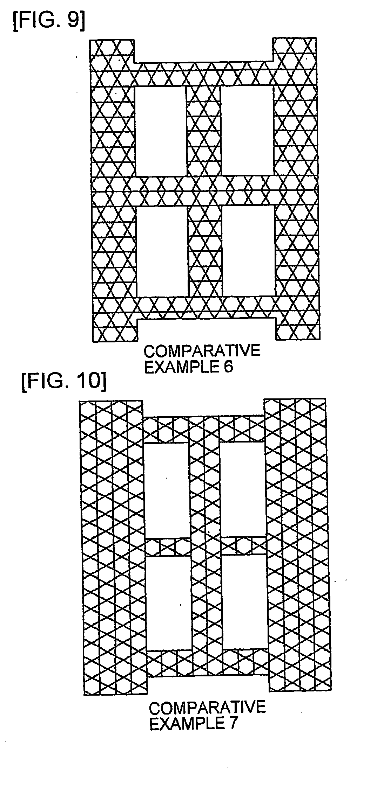

Honeycomb structural bodies having various shapes are shown in Figs. 4 to 10 as Comparative Examples 1 to 7, respectively. It is understood that all the shown honeycomb structural bodies have inner walls that are not perpendicular to the outer walls of the honeycomb structural bodies, respectively. Herein, the prismatic spaces of Comparative Example 1 shown in Fig. 4 are square, the prismatic spaces of each of Comparative Examples 2 and 3 shown in Figs. 5 and 6 are triangular, the prismatic spaces of each of Comparative Examples 4 and 5 shown in Figs. 7 and 8 are hexagonal, and the prismatic spaces of each of Comparative Examples 6 and 7 shown in Figs. 9 and 10 are composite polygonal shapes. Further, a solid structural body having no spaces was prepared as Comparative Example 8 for comparison.

The weight of the honeycomb structural body 13 according to Example of this invention shown in Fig. 3 was 1/2 as compared with a structural body having the solid structure.

With respect to Example shown in Fig. 3 and Comparative Examples 1 to 8, the resonant frequencies were measured by applying axial torsional vibration in a longitudinal direction of the stages, i.e. in a direction perpendicular to lateral directions in the figures. The results of the measurement are shown in Table 1.

The measurement results are shown in Table 1 below.

**[Table 1]**

| | Cell Shape | Direction | Resonant Frequency (Hz) | One-Cell Area (mm²) |
|---|---|---|---|---|
| Example | Square | □ | 492 | 169 |
| Comparative Example 1 | Square | ◇ | 414 | |
| Comparative Example 2 | Triangle | △ | 482 | 219 |
| Comparative Example 3 | Triangle | ▷ | 430 | |
| Comparative Example 4 | Hexagon | 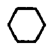 | 466 | 195 |
| Comparative Example 5 | Hexagon | 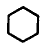 | 477 | |
| Comparative Example 6 | Triangle+ Hexagon | 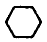 | 446 | 429 |
| Comparative Example 7 | Triangle+ Hexagon | 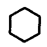 | 468 | |
| Comparative Example 8 | Solid | - | 539 | - |

As clear from Table 1, the resonant frequency is the highest in the honeycomb structural body 13 according to Example of this invention wherein the prismatic spaces of the honeycomb structural body each have the square shape and are arranged in the direction parallel to the longitudinal direction of the stage member. This is presumed to be caused by the fact that the walls forming the spaces are arranged in the perpendicular direction with respect to torsional deformation and further that the area of each square cell is the smallest as compared with the other cell shapes.

Among Comparative Examples having any other prismatic shapes and square shape, Comparative Examples 1, 2, 4, and 6 have the prismatic spaces arranged in a direction inclined by 45° with respect to the longitudinal direction of the stage member. In this event, the walls surrounding the prismatic spaces are arranged at 30 to 45° with respect to torsional deformation and, as a result, weaken resistance to deformation. On the other hand, Comparative Examples 3 and 5 have the walls that surround the prismatic spaces and that are arranged in the perpendicular direction with respect to torsional deformation. In this event, each area of the prismatic spaces is larger than that of Example and results in smaller resistance to torsional deformation.

### Industrial Applicability

While the description has been made of the embodiment in which this invention is applied to the liquid crystal panel exposure apparatus, this invention is, of course, also applicable to a semiconductor device exposure apparatus. Further, this invention is applicable not only to an exposure apparatus that simultaneously moves a mask and a substrate, but also to a stage of an exposure apparatus that moves only one of them.

## Claims

1. An exposure apparatus adapted to transfer/expose a pattern of a mask onto a substrate while moving at least one of said mask and said substrate by a ceramic stage member, wherein said stage member comprises a plate member of a ceramic material, a honeycomb structural body of a ceramic material and joined to said plate member at its opening surface, and a joining portion joining together said plate member and said honeycomb structural body and made of a ceramic material having a melting temperature lower than that of the ceramic material or materials forming said plate member and said honeycomb structural body,
said exposure apparatus **characterized in that** prismatic spaces of said honeycomb structural body each have a square shape and walls of said prismatic spaces are arranged in a direction perpendicular to a longitudinal direction of said stage member.

2. An exposure apparatus according to claim 1, **characterized in that** said stage member has a structure in which ceramic plates are joined to said honeycomb structural ceramic body on its upper and lower sides.

3. An exposure apparatus according to claim 1 or 2, **characterized in that** a total mass of said stage member is 1/4 to 1/2 in comparison with that of a ceramic dense body which is free from said prismatic spaces of said honeycomb structural ceramic body.

4. An exposure apparatus according to any one of claims 1 to 3, **characterized in that** the ceramic forming said plate member and said honeycomb structural body and the ceramic forming said joining portion are respectively made of a composite material obtained by combining a first material formed by one or more selected from a group consisting of lithium aluminosilicate, potassium zirconium phosphate, and cordierite, and a second material formed by one or more selected from a group consisting of silicon carbide, silicon nitride, sialon, alumina, zirconia, mullite, zircon, aluminum nitride, calcium silicate, and boron carbide, and that said composite material at 23°C has an average thermal expansion coefficient of -0.1×10⁻⁶ to 0.1×10⁻⁶/°C, a density of 2.45 to 2.55g/cm³, and a Young's modulus of 130 to 160GPa.

5. An exposure apparatus according to claim 1, **characterized in that** said stage member has a structure in which said prismatic spaces of said honeycomb structural ceramic body are hermetically sealed.

6. An exposure apparatus according to any one of claims 1 to 5, **characterized in that** a difference between an average thermal expansion coefficient of said plate member and said honeycomb structural body at 23°C and that of said joining portion at 23°C falls within the range of ±0.1×10⁻⁶/°C.

7. An exposure apparatus according to claim 6, **characterized in that** said stage member has a structure that physically withstands a difference in stress caused by a gas pressure difference between an inside and an outside.

8. A liquid crystal panel exposure apparatus adapted to transfer/expose a pattern of a mask onto a substrate while moving at least one of said mask and said substrate by a ceramic stage member,
said liquid crystal panel exposure apparatus **characterized in that** a ceramic material forming said stage member is made of a composite material obtained by combining a first material formed by one or more selected from a group consisting of lithium aluminosilicate, potassium zirconium phosphate, and cordierite, and a second material formed by one or more selected from a group consisting of silicon carbide, silicon nitride, sialon, alumina, zirconia, mullite, zircon, aluminum nitride, calcium silicate, and boron carbide, and that said composite material at 23°C has an average thermal expansion coefficient of - 0.1×10⁻⁶ to 0.1×10⁻⁶/°C, a density of 2.45 to 2.55g/cm³, and a Young's modulus of 130 to 160GPa.

9. A liquid crystal panel exposure apparatus according to claim 8, **characterized in that** said stage member has a structure in which ceramic plates of said composite material are joined to a honeycomb structural ceramic body of said composite material, on its upper and lower sides.

10. A liquid crystal panel exposure apparatus according to claim 8 or 9, **characterized in that** a total mass of said stage member is 1/4 to 1/2 as compared with that of a dense body which is free from prismatic spaces portions of said honeycomb structural ceramic body and which is formed by said composite material.

11. A stage member comprising a plate member of a ceramic material and a honeycomb structural body of a ceramic material and joined to said plate member at its opening surface, said stage member **characterized in that** prismatic spaces of said honeycomb structural body each have a square shape and walls of said prismatic spaces are arranged in a direction perpendicular to a longitudinal direction of said stage member.

## Amended claims

### Amended claims under Art. 19.1 PCT

**4.** material formed by one or more selected from a group consisting of silicon carbide, silicon nitride, sialon, alumina, zirconia, mullite, zircon, aluminum nitride, calcium silicate, and boron carbide, and that said composite material at 23°C has an average thermal expansion coefficient of -0.1×10⁻⁶ to 0.1×10⁻⁶/°C, a density of 2.45 to 2.55g/cm³, and a Young's modulus of 130 to 160GPa.

**5.** An exposure apparatus according to claim 1, **characterized in that** said stage member has a structure in which said prismatic spaces of said honeycomb structural ceramic body are hermetically sealed.

**6.** An exposure apparatus according to any one of claims 1 to 5, **characterized in that** a difference between an average thermal expansion coefficient of said plate member and said honeycomb structural body at 23°C and that of said joining portion at 23°C falls within the range of ±0.1×10⁻⁶/°C.

**7.** An exposure apparatus according to claim 6, **characterized in that** said stage member has a structure that physically withstands a difference in stress caused by a gas pressure difference between an inside and an outside.

**8.** (deleted)

**9.** (deleted)

**10.** (deleted)

**11.** A stage member comprising a plate member of a ceramic material and a honeycomb structural body of a ceramic material and joined to said plate member at its opening surface, said stage member **characterized in that** prismatic spaces of said honeycomb structural body each have a square shape and walls of said prismatic spaces are arranged in a direction perpendicular to a longitudinal direction of said stage member.
